(19) **Europäisches Patentamt**
**European Patent Office**
**Office européen des brevets**

(11) **EP 3 377 911 B1**

(12) **EUROPÄISCHE PATENTSCHRIFT**

(45) Veröffentlichungstag und Bekanntmachung des Hinweises auf die Patenterteilung:
**07.08.2019 Patentblatt 2019/32**

(51) Int Cl.:
*H02M 1/32* *(2007.01)* *H02M 7/162* *(2006.01)*
*H02J 7/24* *(2006.01)* *G01R 31/00* *(2006.01)*
*G01R 31/34* *(2006.01)*

(21) Anmeldenummer: **16790931.6**

(22) Anmeldetag: **28.10.2016**

(86) Internationale Anmeldenummer:
**PCT/EP2016/076007**

(87) Internationale Veröffentlichungsnummer:
**WO 2017/084857 (26.05.2017 Gazette 2017/21)**

(54) **VERFAHREN ZUM ERKENNEN EINES FEHLERS IN EINER GENERATOREINHEIT**

METHOD FOR DETECTING AN ERROR IN A GENERATOR UNIT

PROCÉDÉ DE DÉTECTION D'UNE DÉFAILLANCE DANS UN GROUPE GÉNÉRATEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.11.2015 DE 102015222733**

(43) Veröffentlichungstag der Anmeldung:
**26.09.2018 Patentblatt 2018/39**

(73) Patentinhaber: **Robert Bosch GmbH**
**70442 Stuttgart (DE)**

(72) Erfinder:
• **MEHRINGER, Paul**
**70569 Stuttgart (DE)**

• **RIEDERER, Miriam**
**70734 Fellbach (DE)**
• **PAULUS, Sebastian**
**73728 Esslingen am Neckar (DE)**
• **MUELLER, Manuel**
**88353 Kisslegg (DE)**
• **ERSEK, Zoltan**
**70825 Korntal-Muenchingen (DE)**

(56) Entgegenhaltungen:
WO-A2-2015/028744    DE-A1- 10 347 185
DE-A1-102013 200 637    US-B2- 7 791 352

**Beschreibung**

Die vorliegende Erfindung betrifft ein Verfahren zum Erkennen eines Fehlers in einer Generatoreinheit sowie eine Recheneinheit, insbesondere einen Generatorregler, und ein Computerprogramm zu dessen Durchführung.

Stand der Technik

Kraftfahrzeuge verfügen über ein Bordnetz, das über eine als Generator betriebene elektrische Maschine, bspw. eine fremderregte Synchronmaschine, mit Spannung versorgt wird. Zur Regelung der Bordnetzspannung kann dabei ein Erregerstrom der elektrischen Maschine gesteuert werden. Die elektrische Maschine ist dabei in der Regel über einen Gleichrichter an das Bordnetz angeschlossen und bildet mit diesem eine Generatoreinheit. Bei solchen Generatoreinheiten können Fehler wie bspw. Kurzschlüsse auftreten, die nach Möglichkeit erkannt werden sollten.

Aus der nicht vorveröffentlichten DE 10 2015 211 933 ist ein Verfahren zum Erkennen eines Fehlers in einer Generatoreinheit, welche eine elektrische Maschine) mit Läuferwicklung und Ständerwicklung und einen daran angeschlossenen Gleichrichter, über den die elektrische Maschine an ein Bordnetz eines Kraftfahrzeugs angeschlossen ist, aufweist, bekannt, wobei über einen Erregerstrom durch die Läuferwicklung der elektrischen Maschine eine Spannung des Bordnetzes auf einen Sollwert geregelt und ein Verlauf des Erregerstroms überwacht wird, und wobei auf einen Fehler in der Generatoreinheit geschlossen wird, wenn ein oszillierender Verlauf des Erregerstroms erkannt wird, wobei ein Ausmaß der Oszillation über einem Schwellwert liegt.

Die WO 2015/028744 A2 (SAGEM DEFENSE SECURITE, 5. März 2015) offenbart ein Verfahren zum Erkennen eines Fehlers in einer Generatoreinheit, welche eine elektrische Maschine mit Läuferwicklung und Ständerwicklung und einen daran angeschlossenen Gleichrichter, über den die elektrische Maschine an ein Bordnetz eines Kraftfahrzeugs angeschlossen ist, aufweist.

Offenbarung der Erfindung

Erfindungsgemäß werden ein Verfahren zum Erkennen eines Fehlers in einer Generatoreinheit sowie eine Recheneinheit und ein Computerprogramm zu dessen Durchführung mit den Merkmalen der unabhängigen Patentansprüche vorgeschlagen. Vorteilhafte Ausgestaltungen sind Gegenstand der Unteransprüche sowie der nachfolgenden Beschreibung.

Vorteile der Erfindung

In einem ersten Aspekt betrifft die Erfindung ein Verfahren zum Erkennen eines Fehlers in einer Generatoreinheit, welche eine elektrische Maschine mit Läuferwicklung und Ständerwicklung und einen daran angeschlossenen Gleichrichter, über den die elektrische Maschine an ein Bordnetz eines Kraftfahrzeugs angeschlossen ist, aufweist, wobei ein zeitlicher Verlauf eines durch die Läuferwicklung der elektrischen Maschine fließenden Erregerstrom erfasst wird, und wobei abhängig davon auf einen Fehler in der Generatoreinheit geschlossen wird, ob ein Frequenzanteil eines Frequenzspektrums des Verlaufs des Erregerstroms in einem Frequenzbereich oberhalb einer vorgebbaren unteren Drehzahlgrenze größer ist als ein vorgebbarer Schwellenwert. Die vorgebbaren untere Drehzahlgrenze und/oder der vorgebbare Schwellenwert können hierbei variabel vorgebbar sein, oder auch auf einen festen Wert vorgegeben sein.

Auf diese Weise können auf einfache Weise verschiedene Arten von Fehlern im Gleichrichter und/oder der elektrischen Maschine erkannt werden. Dies ist möglich, da sich solche Fehler auf den Erregerstrom auswirken. Während durch einen einfachen Vergleich zwischen einer Phasenspannung und der Hälfte der Batterie- bzw. Bordnetzspannung bspw. keine Abtrennung einer kompletten Phase vom Gleichrichter erkennen lässt, wirkt sich eine solche Abtrennung jedoch auf den Erregerstrom aus.

Es wurde erkannt, dass Oszillationen bzw. Schwingungen im Erregerstrom insbesondere dann auftreten, wenn sich Ungleichmäßigkeiten bei den Phasenströmen einstellen, bspw. aufgrund eines Kurzschlusses oder einer Unterbrechung. Da sich Schwingungen besonders einfach erkennen lassen, ergibt sich daher eine einfache und effektive Möglichkeit, Fehler im Gleichrichter und/oder der elektrischen Maschine zu erkennen. Es wurde erkannt, dass diese Oszillationen eine deutliche Signatur im Frequenzspektrum zeigen, das der Verlauf des Erregerstroms hat. Durch eine Analyse dieses Frequenzspektrums lässt sich besonders einfach ein Fehler in der Generatoreinheit erkennen.

Zweckmäßigerweise umfasst der Fehler einen Kurzschluss und/oder eine Unterbrechung in einem High-Side- Pfad zwischen dem Gleichrichter und dem Bordnetz, einen Kurzschluss und/oder eine Unterbrechung in einem Low- Side-Pfad zwischen dem Gleichrichter und dem Bordnetz und/oder eine Abtrennung einer Phase von dem Gleichrichter und/oder einen Kurzschluss von Phasen zueinander. In der elektrischen Maschine kann der Fehler einen Kurzschluss des Ständers gegen das Bordnetz, d.h. gegen positive (B+) und/oder negative (B-) Spannung, eine Unterbrechung in einem Draht der Ständerwicklung, einen Kurzschluss zwischen Drähten der Ständerwicklung und/oder einen Kurzschluss zwischen verschiedenen Phasen umfassen. Da eine elektrische Maschine wie bspw. eine fremderregte Synchronmaschine bspw. drei oder fünf Phasen aufweist, kann auch ein Fehler auftreten, der verschiedene Phasen umfasst, wenngleich dies auch unwahrscheinlich ist. Insofern können bspw. auch Fehler, die einen Kurzschluss und eine Abtrennung zweier verschiedener Pfade umfassen, auftreten. Bei den genannten Fehlern handelt es sich dabei um die üblicherweise auftretenden Fehler bei Generatoreinheiten. Insbesondere Kurzschlüsse oder Unterbrechungen eines Pfades führen dabei zu deutlichen Schwingungen im Erregerstrom, die einfach erkannt werden können. Ebenso führt aber eine Abtrennung einer kompletten Phase, d.h. eine Unterbrechung sowohl am High-Side- als auch am Low-Side-Pfad derselben Phase, aufgrund der geänderten Ströme zu einer Schwingung im Erregerstrom. Dies hat auf die Grundfrequenz der Spannung einer einzelnen Phase keinen Einfluss hat, solange es nicht die einzige überwachte Phase betrifft. Mit dem eingangs erwähnten und bekannten Verfahren mit Überwachung einer Phase, wie dies mit herkömmlichen Reglern der Fall ist, ist daher in der Regel eine solche Abtrennung einer Phase nicht erkennbar.

In einem weiteren Aspekt kann vorgesehen sein, dass dann auf den Fehler in der Generatoreinheit geschlossen wird, wenn eine kumulative Verteilungsfunktion des Frequenzspektrums in dem Frequenzbereich oberhalb der unteren Drehzahlgrenze größer ist als der vorgebbare Schwellenwert. Dieses Verfahren ist besonders einfach.

In einem weiteren Aspekt kann vorgesehen sein, dass eine Fehlerfrequenz ermittelt wird, in deren Umgebung der Frequenzanteil des Frequenzspektrums des Verlaufs des Erregerstroms größer ist als ein vorgebbarer Schwellenwert. Dies bedeutet, dass die Summe aller Frequenzanteile zu den Frequenzen, die innerhalb dieser Umgebung liegen, größer ist als der vorgebbare Schwellenwert. Die Umgebung kann insbesondere ein nach unten durch eine untere Frequenzkante und nach oben durch eine obere Frequenzkante begrenzter Bereich sein, insbesondere ein Bereich fester oder fest vorgebbarer Breite, wobei die Fehlerfrequenz innerhalb dieses Bereichs liegt. Es hat sich gezeigt, dass abhängig davon, welcher Fehler in der Generatoreinheit vorliegt, die Frequenzanteile unterschiedlicher Frequenzen im Frequenzspektrum des Verlaufs des Erregerstroms große Werte annehmen. Durch Extraktion einer oder mehrerer Fehlerfrequenzen ist es möglich, besonders zuverlässig zu identifizieren, welcher Fehler vorliegt.

Insbesondere ist es möglich, dass eine Zuordnung von Fehlerfrequenzen zu möglichen Fehlern vorgehalten wird. Dann kann vorgesehen sein, dass für Fehler aus einer Liste möglicher Fehler in der Generatoreinheit abhängig vor der ermittelten Fehlerfrequenz darauf entschieden wird, ob dieser Fehler in der Generatoreinheit vorliegt, oder nicht. Es ist dann insbesondere auch möglich, dass für mehr als einen der Fehler aus der Liste möglicher Fehler in der Generatoreinheit darauf entschieden wird, dass dieser Fehler vorliegt. Auf diese Weise lässt sich auf besonders einfache Weise eine umfassende Diagnose der Generatoreinheit durchführen.

Insbesondere kann hierbei vorgesehen sein, dass die Liste möglicher Fehler einen Kurzschluss und/oder eine Unterbrechung in einem High-Side-Pfad, einen Kurzschluss und/oder eine Unterbrechung in einem Low-Side-Pfad zwischen dem Gleichrichter und dem Bordnetz und/oder eine Abtrennung einer der Phasen von dem Gleichrichter umfasst, und wobei abhängig von der ermittelten Fehlerfrequenz darauf entschieden wird, welcher dieser Fehler vorliegt. Es wurde herausgefunden, dass sich anhand der Fehlerfrequenz besonders einfach differenzieren lässt, ob der Kurzschluss oder die Abtrennung der Phase vorliegt.

Es kann vorgesehen sein, dass dann, wenn die ermittelte Fehlerfrequenz einer Drehzahl des Generators multipliziert mit einer Polpaarzahl des Generators entspricht, darauf entschieden wird, dass der Kurzschluss im High-Side-Pfad oder der Fehler im Low-Side-Pfad vorliegt. Ob dieser Kurzschluss High-Side-seitig oder Low-Side-seitig vorliegt, kann anhand der Fehlerfrequenz zunächst nicht differenziert werden.

Diese Differenzierung ist aber abhängig von einem zeitlichen Verlauf einer Phasenspannung möglich. Insbesondere ist es hier nicht erforderlich, dass die Phase, in deren High-Side-Pfad oder Low-Side-Pfad der Kurzschluss vorliegt und die Phase, deren zeitlicher Verlauf der Phasenspannung ausgewertet wird, die gleiche Phase ist.

In einem weiteren Aspekt kann vorgesehen sein, dass dann, wenn darauf entschieden wird, dass der Kurzschluss im High-Side-Pfad oder der Fehler im Low-Side-Pfad vorliegt, eine Reduzierung des Betrags des Erregerstroms oder eine Pulsung des Erregerstroms durchgeführt wird. Die Pulsung bedeutet, dass eine Taktfrequenz eines mit der Läuferwicklung in Reihe geschalteten Schalters reduziert wird. Die Taktfrequenz sollte hierbei vorteilhafterweise so weit reduziert werden, dass eine Periodendauer gerade noch kleiner ist als eine thermische Einschwingzeit eines Drahtes der Ständerwicklung, insbesondere auf eine Taktfrequenz auf weniger als 1/s, beispielsweise 0,1/s.

Durch eine Reduktion des Erregerstroms wird auch der im Ständer fließende Strom reduziert, sodass sich auch die Rückkopplung auf den Erregerstrom reduziert. Auf diese Weise lassen sich Fehler besonders sicher unterdrücken, indem effektiv eine Abgabeleistung des Generators reduziert wird.

In einem weiteren Aspekt kann vorgesehen sein, dass dann auf die Abtrennung entschieden wird, wenn die ermittelte Fehlerfrequenz dem Doppelten einer Drehzahl des Generators multipliziert mit einer Polpaarzahl des Generators entspricht.

Wenn andererseits erkannt wurde, dass ein Fehler in der Generatoreinheit vorliegt, aber für keinen der Fehler aus einer Liste möglicher Fehler entschieden wird, dass dieser Fehler vorliegt, kann vorgesehen sein, dass der Generator abgeschaltet wird. Dies macht das Verfahren besonders sicher.

Eine erfindungsgemäße Recheneinheit, insbesondere ein Generatorregler, z.B. ein Steuergerät eines Kraftfahrzeugs, ist, insbesondere programmtechnisch, dazu eingerichtet, ein erfindungsgemäßes Verfahren durchzuführen.

Auch die Implementierung des Verfahrens in Form eines Computerprogramms ist vorteilhaft, da dies besonders geringe Kosten verursacht, insbesondere wenn ein ausführendes Steuergerät noch für weitere Aufgaben genutzt wird und daher ohnehin vorhanden ist.

Weitere Vorteile und Ausgestaltungen der Erfindung ergeben sich aus der Beschreibung und der beiliegenden Zeichnung.

Die Erfindung ist anhand eines Ausführungsbeispiels in der Zeichnung schematisch dargestellt und wird im Folgenden unter Bezugnahme auf die Zeichnung beschrieben.

Kurze Beschreibung der Zeichnungen

Figur 1                         zeigt schematisch eine Generatoreinheit mit elektrischer Maschine, Gleichrichter und Generatorregler, bei der ein erfindungsgemäßes Verfahren durchführbar ist.

Figuren 2 bis 5                 zeigen die Generatoreinheit aus Figur 1 mit verschiedenen Fehlern im Gleichrichter.

Figuren 6 bis 9                 zeigen in Diagrammen Spannungs- und Stromverläufe zu den in den Figuren 2 bis 5 gezeigten Fehlern.

Figur 10a und 10b              zeigen jeweils ein Amplitudenspektrum des Verlaufs des Erregerstroms.

Figur 11                        zeigt den Verlauf einer Phasenspannung Falle eines High-Side-Kurzschlusses einer Phase.

Ausführungsform(en) der Erfindung

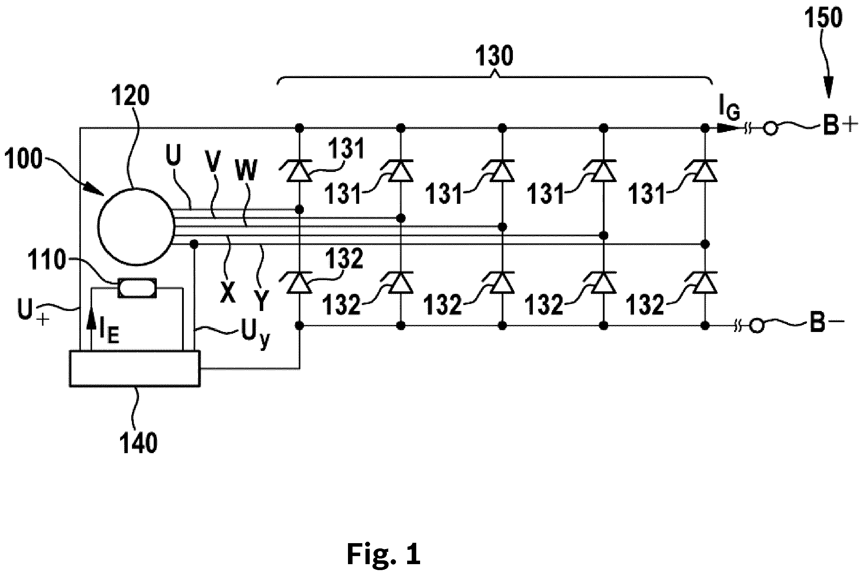

In Figur 1 ist schematisch Generatoreinheit aufweisend eine elektrische Maschine 100 mit einem Gleichrichter 130 und einer als Generatorregler ausgebildeten Recheneinheit 140, bei der ein erfindungsgemäßes Verfahren durchführbar ist, gezeigt. Die elektrische Maschine 100 weist eine Läufer- bzw. Erregerwicklung 110 und eine Ständerwicklung 120 auf und wird vorliegend als Generator zur Spannungsversorgung für ein Bordnetz 150 eines Kraftfahrzeuges verwendet.

Die elektrische Maschine 100 und somit deren Ständerwicklung 120 ist vorliegend mit fünf Phasen U, V, W, X und Z ausgebildet. Jede der fünf Phasen ist dabei über eine zugehörige Diode 131 des Gleichrichters 130 an eine positive Seite bzw. High-Side B+ des Bordnetzes 150 und über eine zugehörige Diode 132 an eine negative Seite bzw. Low-Side B- des Bordnetzes 150 angebunden. Es versteht sich, dass die Anzahl fünf der Phasen vorliegend nur beispielhaft gewählt ist und dass ein erfindungsgemäßes Verfahren auch mit einer anderen Phasenanzahl, bspw. 3, 6, 7 oder mehr durchführbar ist. Ebenso ist es möglich, anstelle der Dioden geeignete Halbleiterschalter zu verwenden.

Der Generatorregler 140 versorgt die Läuferwicklung 110 mit einem Erregerstrom $I_E$. Hierzu kann im Generatorregler 140 ein Schalter vorgesehen sein, der mit der Läuferwicklung 110 in Reihe geschaltet ist, und der den Erregerstrom $I_E$ beispielsweise durch eine getaktete Ansteuerung einstellt. Weiterhin weist der Generatorregler 140 Eingänge zum Erfassen der Bordnetzspannung mit B+ und B-sowie einer Phasenspannung, vorliegend der Phase Y, mit Spannung $U_Y$ auf. Ein von der elektrischen Maschine 100 abgegebener Strom ist mit $I_G$ bezeichnet.

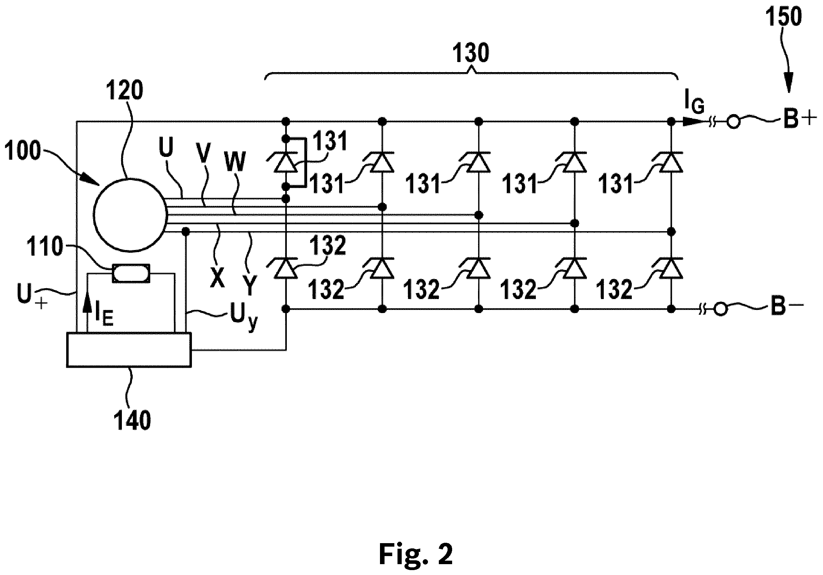

In den Figuren 2 bis 5 ist jeweils die Anordnung aus Figur 1 gezeigt mit jeweils einem spezifischen Fehler im Gleichrichter 130.

In Figur 2 ist beispielhaft ein Kurzschluss im High-Side-Pfad, vorliegend bei der Phase U, gezeigt. Dies kann bspw. bei einem Kurzschluss der zugehörigen Diode 131 auftreten.

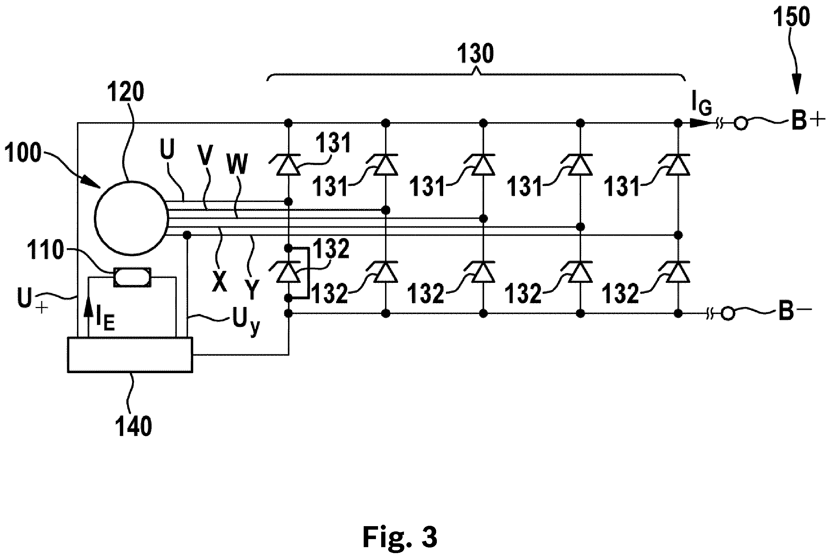

In Figur 3 ist beispielhaft ein Kurzschluss im Low-Side-Pfad, vorliegend bei der Phase U, gezeigt. Dies kann bspw. bei einem Kurzschluss der zugehörigen Diode 132 auftreten.

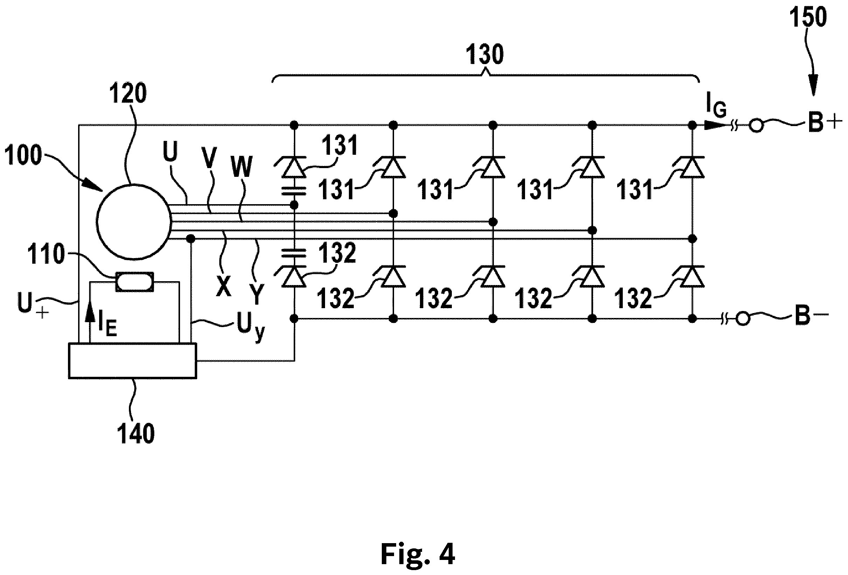

In Figur 4 ist beispielhaft eine abgetrennte Phase, vorliegend die Phase U, gezeigt. Dies kann bspw. bei einer Abtrennung oder Zerstörung (nichtleitender Zustand) der beiden zugehörigen Dioden 131 und 132 auftreten. Ebenso tritt dieser Fehler jedoch bei einer Abtrennung der zughörigen Leitung zur Ständerwicklung 120 auf, welche an beide Dioden angebunden ist.

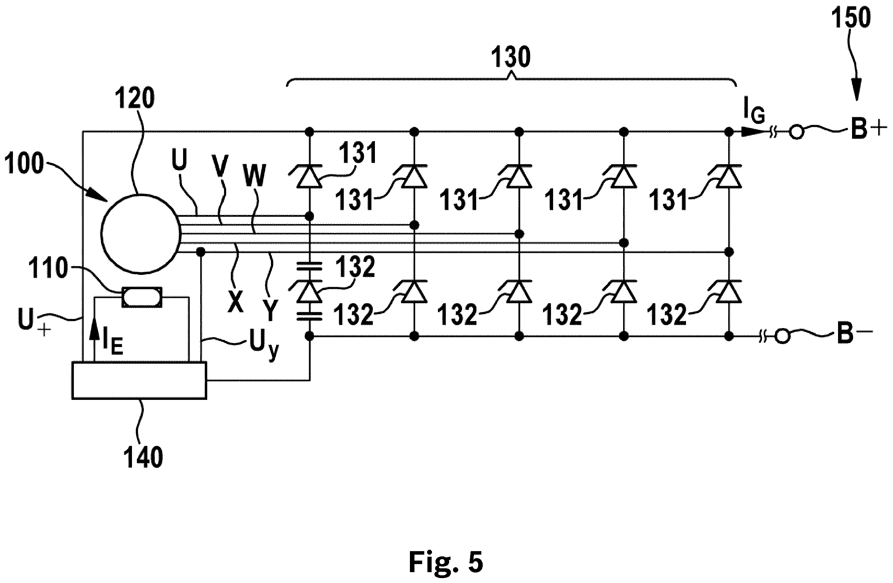

In Figur 5 ist beispielhaft eine Unterbrechung in einem Low-Side-Pfad, vorliegend bei der Phase U, gezeigt. Eine solche Unterbrechung tritt bspw. auf, wenn die zugehörige Diode 132 an einer Seite der Diode, oder, wie in der Figur gezeigt, auf beiden Seiten der Diode abgetrennt ist, oder wenn die Diode bspw. zerstört ist. Eine Unterbrechung in einem High-Side-Pfad würde dementsprechend bspw. bei einer Abtrennung oder Zerstörung einer Diode 131 auftreten.

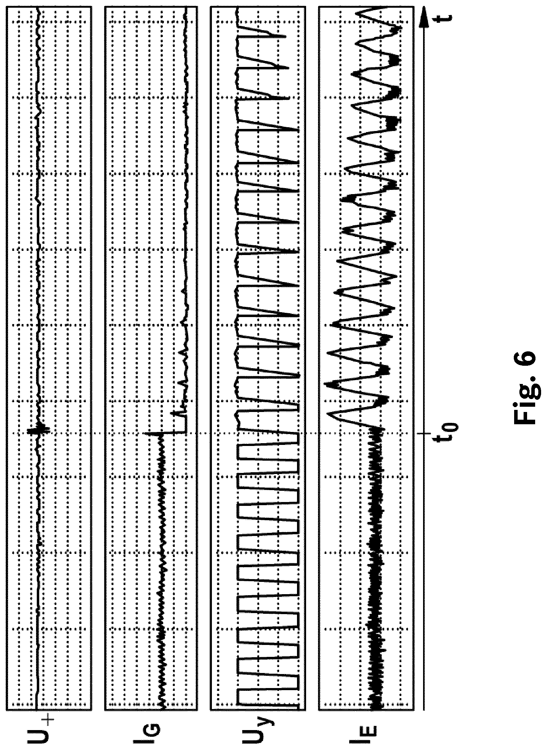

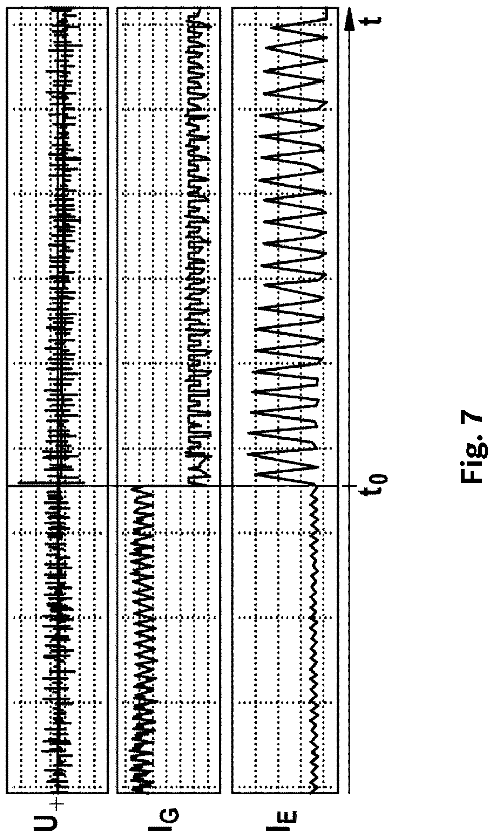

In den Figuren 6 bis 9 sind jeweils Verläufe der Generatorspannung U+, des Generatorstroms $I_G$, der Phasenspannung $U_Y$ der Phase Y (nicht in Figur 7) und des Erregerstroms $I_E$ über der Zeit t gezeigt. Vor dem Zeitpunkt to herrscht ein normaler Betrieb der Anordnung und zum Zeitpunkt to tritt ein Fehler in der Generatoreinheit auf. Den Verläufen in den Figuren 6 bis 9 entsprechen dabei Verläufe, wie sie Fehlern, wie in den Figuren 2 bis 5 gezeigt, entsprechen. Hierzu sei angemerkt, dass die Skalierung der einzelnen Diagramme sowohl bei Strom bzw.

Spannung als auch bei der Zeit nicht immer übereinstimmen, was für die vorliegende Erfindung jedoch nicht relevant ist.

In Figur 6 ist zu sehen, dass sich ein Kurzschluss in einem High-Side-Pfad bei der Generatorspannung nur kurzzeitig nach Auftreten des Fehlers bemerkbar macht. Der Generatorstrom nimmt ab und die Phasenspannung verändert sich hinsichtlich ihres Schwingungsmusters. Im Erregerstrom ist eine deutliche Schwingung mit hoher Amplitude im Vergleich zum Verlauf ohne Fehler zu sehen. Wenngleich in diesem Fall der Fehler auch an der Phasenspannung erkennbar wäre, so ist der Fehler im Verlauf des Erregerstroms noch deutlicher zu erkennen. Die Frequenz f der Schwingung in 1/s entspricht hier:

$$f = n \cdot PPZ / 60,$$

wobei n die Drehzahl des Generators in 1/min und PPZ die Polpaarzahl des Generators darstellt.

Dieser Verlauf des Erregerstroms resultiert aus einer unsymmetrischen Verteilung der Phasenströme nach dem Kurzschluss, die dann einen Gleichstromanteil enthalten. Mit der Drehung der elektrischen Maschine werden diese ungleichen Gleichstromanteile dann auf den Läufer der elektrischen Maschine übertragen, da die fremderregte Synchronmaschine wie ein Transformator betrachtet werden kann, der einerseits eine Kopplung vom Läufer auf den Ständer, andererseits aber auch eine Rückkopplung vom Ständer auf den Läufer ermöglicht. Der Erregerstrom erhält dadurch einen deutlichen Wechselstromanteil, wodurch der Rückschluss auf den Kurzschluss möglich ist.

In Figur 7 ist zu sehen, dass sich ein Kurzschluss in einem Low-Side-Pfad bei der Generatorspannung nur kurzzeitig nach Auftreten des Fehlers bemerkbar macht und dass der Generatorstrom abnimmt. Im Erregerstrom ist, wie auch beim Kurzschluss im High-Side-Pfad, eine deutliche Schwingung mit hoher Amplitude im Vergleich zum Verlauf ohne Fehler zu sehen, wodurch der Kurzschluss erkannt werden kann.

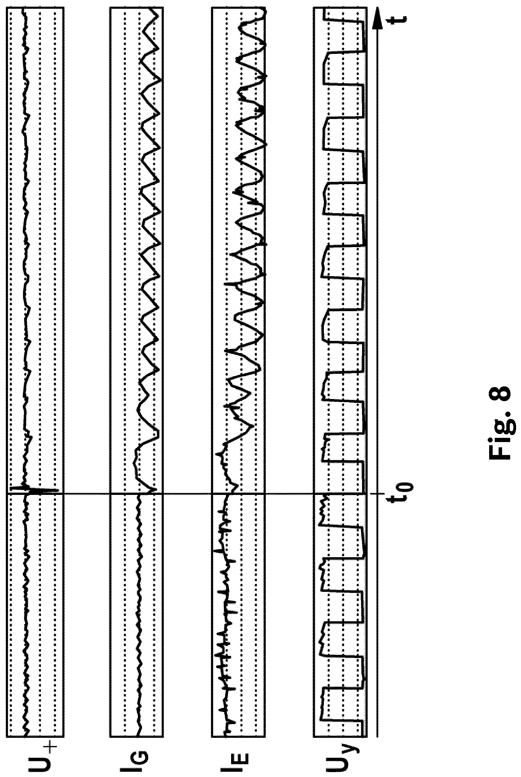

In Figur 8 ist zu sehen, dass eine Abtrennung einer ganzen Phase sich bei der Generatorspannung kurzzeitig nach Auftreten des Fehlers durch eine größere Schwankung in der Spannung und anschließend nur noch geringfügig durch leichte Schwankungen bemerkbar macht. Der Generatorstrom geht in eine Schwingung mit erhöhter Amplitude über. Der Erregerstrom nimmt leicht ab und geht in eine Schwingung mit deutlich höherer Amplitude als vor Auftreten des Fehlers über. Die Phasenspannung an der abgetrennten Phase wird nicht mehr über eine Gleichrichtung begrenzt, sie zeigt daher die deutlich höhere Leerlaufspannung der elektrischen Maschine. An den nicht beschädigten Phasen (wie beispielhaft in der Figur gezeigt) wird sich allerdings die Phasenspannung nicht ändern.

Eine Erkennung einer abgetrennten Phase anhand der Phasenspannung ist somit nicht möglich, außer der Defekt würde zufällig die einzige Phase betreffen, die überwacht wird. Am Erregerstrom hingegen ist eine Abtrennung einer Phase deutlich zu erkennen. Wiederum tritt hier eine unsymmetrische Phasenstromverteilung auf. Bei Kurzschlüssen oder Unterbrechungen ergibt sich ständerseitig ein zusätzlicher Gleichstromanteil, der als Wechselstromanteil auf die Läuferseite übertragen wird. Bei der Abtrennung einer Phase wird der Phasenstrom in der entsprechenden Phase hingegen auf Null reduziert. Dementsprechend müssen die verbliebenen Phasen diesen Anteil kompensieren und werden somit asymmetrisch belastet. Im Fehlerfall der abgefallenen Phase ist die Frequenz der Oszillation doppelt so hoch wie bei den vorher aufgezeigten Fehlerfällen und lässt sich somit eindeutig von diesen unterscheiden.

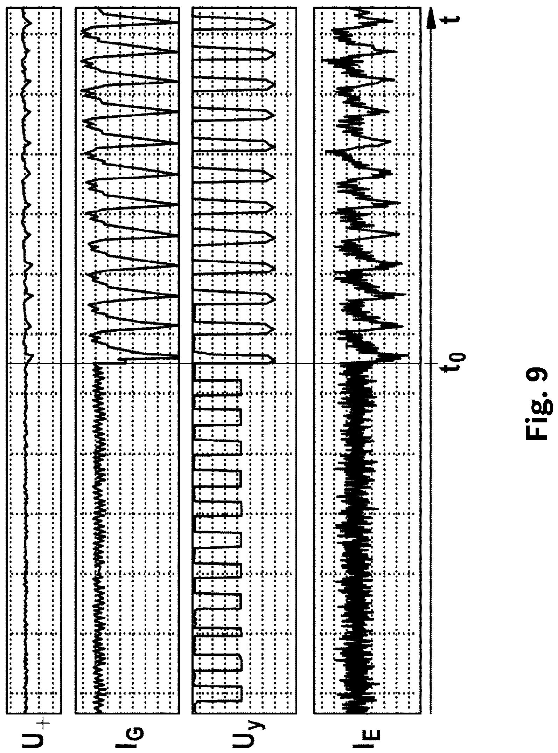

In Figur 9 ist zu sehen, dass eine Unterbrechung in einem Low-Side-Pfad zu leichten Schwankungen in der Generatorspannung führt. Der Generatorstrom folgt einer Schwingung, bei der der Wert des Stroms jeweils mit Erreichen des jeweiligen abgetrennten Low-Side-Pfades gegen Null geht. Die Phasenspannung weist eine höhere Amplitude als vor dem Fehler auf und der Erregerstrom weist ebenfalls eine Schwingung mit deutlich erhöhter Amplitude auf.

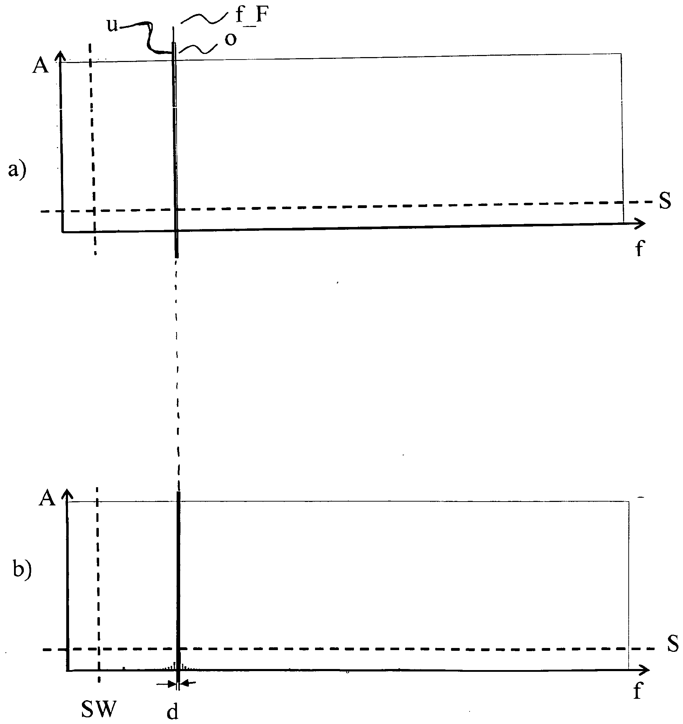

In Figur 10a und 10b ist jeweils ein Amplitudenspektrum des Verlaufs des Erregerstroms $I_E$ dargestellt. Aufgetragen ist der Betrag A des Frequenzspektrums über der Frequenz f. Figur 10a zeigt eine solches Amplitudenspektrum im Normalfall, Figur 10b in einem der oben illustrierten Fehlerfälle. Wie deutlich zu sehen ist, ergibt sich im Fehlerfall für Frequenzen f oberhalb der unteren Drehzahlgrenze SW ein deutlich erhöhter Frequenzanteil A. Im Bereich zwischen der unteren Frequenzkante u und der oberen Frequenzkante o, die gemeinsam ein Frequenzintervall der Breite d begrenzen, ergibt sich ein Frequenzanteil A, der größer ist, als der Schwellwert S. Innerhalb dieses Frequenzintervalls, beispielsweise in der Mitte zwischen unterer Frequenzkante u und oberer Frequenzkante o, liegt die somit identifizierte Fehlerfrequenz f_F, anhand derer ermittelt werden kann, welcher Fehler in der Generatoreinheit vorliegt.

Aus der bloßen Tatsache, dass überhaupt für ein Frequenzintervall der Breite d der Frequenzanteil A größer ist als der Schwellenwert S lässt sich bereits ableiten, dass ein Fehler vorliegt.

Anhand der Fehlerfrequenz f_F lässt sich insbesondere identifizieren, ob ein Kurzschluss wie in Figuren 2 und 3 illustriert vorliegt. Ob ein in Figur 2 illustrierter Kurzschluss einer Phase nach High-Side oder ein in Figur 3 illustrierter Kurzschluss einer Phase nach Low-Side vorliegt, lässt sich dann mit Hilfe der Phasenspannung $U_Y$ ermitteln.

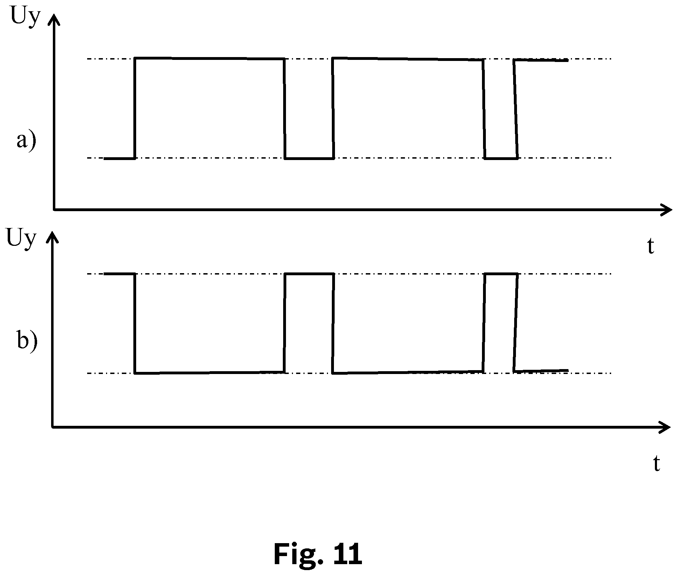

In Figur 11 ist beispielhaft der Verlauf der Phasenspannung $U_Y$ über der Zeit t im Falle eines High-Side-Kurzschlusses der Phase U (Figur 11a) bzw. im Falle eines Low-Side-Kurzschlusses der Phase U dargestellt. Wie ersichtlich, ändert sich das Signal der Dauern der Phasenpegel der Phasenspannung $U_Y$ auf Spannungsniveau "High" bzw. "Low". Im Falle des High-Side-Kurzschlusses ist der "High"-Phasenpegel gegenüber dem "Low"-Phasenpegel verbreitert, im Falle des Low-Side-Kurzschlusses ist es andersherum. Im Normalfall dauern "High"-Phasenpegel und "Low"-Phasenpegel gleich lange an. Dies ist unabhängig von der Phase, in der der Kurzschluss vorliegt.

Sofern der Kurzschluss anders als in Figur 11 illustriert direkt in einer Phase Y anliegt, die mit dem Regler verbunden ist, ergibt sich bei Kurzschluss dieser Phase Y nach der positiven Seite B+ des Bordnetzes 150 ein Verlauf der Phasenspannung $U_Y$ am Regleranschluss der kontinuierlich auf dem hohen Potential dieser positiven Seite B+ liegt. Bei Kurzschluss dieser Phase Y auf die negative Seite B- des Bordnetzes 150 ergibt sich ein Phasenspannungsverlauf, der kontinuierlich auf dem niedrigen Potential dieser niedrigen Seite B- liegt

Somit ist mit Hilfe der Phasenspannung $U_Y$ eine Differenzierung der genannten Fehlerbilder möglich.

Zusammenfassend ist zu sehen, dass anhand des Frequenzspektrums des Erregerstroms alle angesprochenen Fehler im Gleichrichter und/oder der Maschine erkannt werden können. Da der Erregerstrom wegen der Regelung im Generatorregler ohnehin erfasst wird, kann das vorliegende Verfahren sehr einfach realisiert werden.

Es kann auch vorgesehen sein, dass ein erkannter Fehler über eine Schnittstelle einem übergeordneten Steuergerät mitgeteilt wird.

**Patentansprüche**

1. Verfahren zum Erkennen eines Fehlers in einer Generatoreinheit, welche eine elektrische Maschine (100) mit Läuferwicklung (110) und Ständerwicklung (120) und einen daran angeschlossenen Gleichrichter (130), über den die elektrische Maschine (100) an ein Bordnetz (150) eines Kraftfahrzeugs angeschlossen ist, aufweist, wobei ein Verlauf eines durch die Läuferwicklung (110) der elektrischen Maschine (100) fließenden Erregerstroms ($I_E$) erfasst wird, das Verfahren ist **dadurch gekennzeichnet, dass** abhängig davon auf einen Fehler in der Generatoreinheit geschlossen wird, ob ein Frequenzanteil (A) eines Frequenzspektrums des Verlaufs des Erregerstroms ($I_E$) in einem Frequenzbereich oberhalb einer unteren Drehzahlgrenze (SW) größer ist als ein Schwellenwert (S).

2. Verfahren nach Anspruch 1, wobei dann auf den Fehler in der Generatoreinheit geschlossen wird, wenn eine kumulative Verteilungsfunktion des Frequenzspektrums in dem Frequenzbereich oberhalb der unteren (SW) Drehzahlgrenze größer ist als der Schwellenwert (S).

3. Verfahren nach einem der vorherigen Ansprüche, wobei eine Fehlerfrequenz (f_F) ermittelt wird, in deren Umgebung (o, u) der Frequenzanteil (A) des Frequenzspektrums des Verlaufs des Erregerstroms ($I_E$) größer ist als der Schwellenwert (S).

4. Verfahren nach Anspruch 3, wobei für Fehler aus einer Liste möglicher Fehler in der Generatoreinheit abhängig vor der ermittelten Fehlerfrequenz darauf entschieden wird, ob dieser Fehler in der Generatoreinheit vorliegt, oder nicht.

5. Verfahren nach Anspruch 4, wobei die Liste möglicher Fehler einen Kurzschluss und/oder eine Unterbrechung in einem High-Side-Pfad zwischen dem Gleichrichter (130) und dem Bordnetz (150), einen Kurzschluss und/oder eine Unterbrechung in einem Low-Side-Pfad zwischen dem Gleichrichter (130) und dem Bordnetz (150) und/oder eine Abtrennung einer der Phasen (U, V, W, X, Y) von dem Gleichrichter (130) umfasst, und wobei abhängig von der ermittelten Fehlerfrequenz darauf entschieden wird, welcher dieser Fehler vorliegt.

6. Verfahren nach Anspruch 5, wobei die Liste möglicher Fehler den Kurzschluss im High-Side-Pfad und/oder den Fehler im Low-Side-Pfad umfasst, und wobei dann, wenn die ermittelte Fehlerfrequenz einer Drehzahl des Generators multipliziert mit einer Polpaarzahl des Generators entspricht, darauf entschieden wird, dass der Kurzschluss im High-Side-Pfad oder der Fehler im Low-Side-Pfad vorliegt.

7. Verfahren nach Anspruch 6, wobei dann, wenn darauf entschieden wird, dass der Kurzschluss im High-Side-Pfad oder der Fehler im Low-Side-Pfad vorliegt, abhängig von einem zeitlichen Verlauf einer Phasenspannung darauf entschieden wird, welcher dieser beiden Pfade derjenige ist, in dem der Kurzschluss vorliegt.

8. Verfahren nach Anspruch 6 oder 7, wobei dann, wenn darauf entschieden wird, dass der Kurzschluss im High-Side-Pfad oder der Fehler im Low-Side-Pfad vorliegt, ein eine Reduzierung des Betrags des Erregerstroms ($I_E$) oder eine Pulsung des Erregerstroms ($I_E$) durchgeführt wird.

9. Verfahren nach Anspruch 5 oder 6, wobei die Liste möglicher Fehler die Abtrennung einer der Phasen (U, V, W, X, Y) von dem Gleichrichter (130) umfasst, und wobei denn auf die Abtrennung entschieden wird, wenn die ermittelte Fehlerfrequenz dem Doppelten einer Drehzahl des Generators multipliziert mit einer Polpaarzahl des Generators entspricht.

10. Verfahren nach einem der Ansprüche 4 bis 9, wobei dann, wenn erkannt wurde, dass ein Fehler in der Generatoreinheit vorliegt, aber für keinen der Fehler aus einer Liste möglicher Fehler entschieden wird, dass dieser Fehler vorliegt, der Generator abgeschaltet wird.

11. Recheneinheit (140), insbesondere Generatorregler, die dazu eingerichtet ist, ein Verfahren nach einem der vorstehenden Ansprüche durchzuführen.

12. Computerprogramm, das eine Recheneinheit (140) dazu veranlasst, ein Verfahren nach einem der Ansprüche 1 bis 10 durchzuführen, wenn es auf der Recheneinheit (140) ausgeführt wird.

13. Maschinenlesbares Speichermedium mit einem darauf gespeicherten Computerprogramm nach Anspruch 12.

**Claims**

1. Method for detecting a fault in a generator unit, which has an electric machine (100) with rotor winding (110) and stator winding (120) and a rectifier (130) connected thereto, via which the electric machine (100) is connected to an on-board electrical network (150) of a motor vehicle,
wherein a profile of an excitation current ($I_E$) flowing through the rotor winding (110) of the electric machine (100) is identified,
the method is **characterized in that**
a fault is assumed to exist in the generator unit depending on whether a frequency component (A) of a frequency spectrum of the profile of the excitation current ($I_E$) in a frequency range above a lower rotational speed limit (SW) is greater than a threshold value (S).

2. Method according to Claim 1, wherein the fault is assumed to exist in the generator unit when a cumulative distribution function of the frequency spectrum in the frequency range above the lower (SW) rotational speed limit is greater than the threshold value (S).

3. Method according to either of the preceding claims,
wherein a fault frequency (f_F) is determined, the frequency component (A) of the frequency spectrum of the profile of the excitation current ($I_E$) in the vicinity (o, u) of said fault frequency being greater than the threshold value (S).

4. Method according to Claim 3, wherein, for faults from a list of possible faults in the generator unit, a decision is made depending on the determined fault frequency about whether said faults exist in the generator unit or not.

5. Method according to Claim 4, wherein the list of possible faults comprises a short circuit and/or an interruption in a high-side path between the rectifier (130) and the on-board electrical network (150), a short circuit and/or an interruption in a low-side path between the rectifier (130) and the on-board electrical network (150) and/or a disconnection of one of the phases (U, V, W, X, Y) from the rectifier (130), and wherein a decision is made depending on the determined fault frequency about which of said faults exists.

6. Method according to Claim 5, wherein the list of possible faults comprises the short circuit in the high-side path and/or the fault in the low-side path, and wherein, when the determined fault frequency corresponds to a rotational speed of the generator multiplied by a number of pole pairs of the generator, it is decided that the short circuit exists in the high-side path or the fault exists in the low-side path.

7. Method according to Claim 6, wherein, when it is decided that the short circuit exists in the high-side path or the fault exists in the low-side path, a decision is made depending on a time profile of a phase voltage about which of said two paths is the one in which the short circuit exists.

8. Method according to Claim 6 or 7, wherein, when it is decided that the short circuit exists in the high-side path or the fault exists in the low-side path, the magnitude of the excitation current ($I_E$) is reduced or the excitation current

($I_E$) is pulsed.

9. Method according to Claim 5 or 6, wherein the list of possible faults comprises the disconnection of one of the phases (U, V, W, X, Y) from the rectifier (130), and wherein the disconnection is decided upon when the determined fault frequency corresponds to double a rotational speed of the generator multiplied by a number of pole pairs of the generator.

10. Method according to one of Claims 4 to 9, wherein, when it has been detected that a fault exists in the generator unit but it is decided that said fault does not exist for any of the faults from a list of possible faults, the generator is switched off.

11. Processing unit (140), in particular generator regulator, which is configured for implementing a method according to one of the preceding claims.

12. Computer program, which causes a processing unit (140) to implement a method according to one of Claims 1 to 10 when said computer program is executed on the processing unit (140).

13. Machine-readable storage medium having a computer program according to Claim 12 stored thereon.

**Revendications**

1. Procédé de détection d'une défaillance dans un groupe générateur, lequel comporte une machine électrique (100) dotée d'un enroulement de rotor (110) et d'un enroulement de stator (120) et d'un redresseur (130) raccordé à ceux-ci, au moyen duquel la machine électrique (100) est raccordée à un réseau de bord (150) d'un véhicule à moteur, dans lequel une courbe d'un courant d'excitation ($I_E$) traversant l'enroulement de rotor (110) de la machine électrique (100) est saisie, le procédé est **caractérisé en ce que**, en fonction de cette courbe, une défaillance dans le groupe générateur est déduite si une composante de fréquence (A) d'un spectre de fréquence de la courbe du courant d'excitation ($I_E$) dans un intervalle de fréquence au-dessus d'une limite inférieure de vitesse de rotation (SW) est supérieure à une valeur seuil (S).

2. Procédé selon la revendication 1, dans lequel la défaillance dans le groupe générateur est ensuite déduite lorsqu'une fonction de distribution cumulative du spectre de fréquence dans l'intervalle de fréquence au-dessus de la limite inférieure de vitesse de rotation (SW) est supérieure à la valeur seuil (S).

3. Procédé selon l'une des revendications ci-dessus, dans lequel une fréquence de défaillance (f_F) est déterminée, dans les environs (o, u) de laquelle la composante de fréquence (A) du spectre de fréquence de la courbe du courant d'excitation ($I_E$) est supérieure à la valeur seuil (S).

4. Procédé selon la revendication 3, dans lequel pour une défaillance issue d'une liste de défaillances possibles dans le groupe générateur, il est décidé en fonction de la fréquence de défaillance déterminée si cette défaillance existe ou non dans le groupe générateur.

5. Procédé selon la revendication 4, dans lequel la liste de défaillances possibles comprend un court-circuit et/ou une coupure dans un chemin côté haut entre le redresseur (130) et le réseau de bord (150), un court-circuit et/ou une coupure dans un chemin côté bas entre le redresseur (130) et le réseau de bord (150) et/ou une déconnexion d'une des phases (U, V, W, X, Y) du redresseur (130), et dans lequel il est décidé en fonction de la fréquence de défaillance déterminée laquelle de ces défaillances existe.

6. Procédé selon la revendication 5, dans lequel la liste de défaillances possibles comprend le court-circuit dans le chemin côté haut et/ou la défaillance dans le chemin côté bas, et dans lequel ensuite, lorsque la fréquence de défaillance déterminée correspond à une vitesse de rotation du générateur multipliée par un nombre de paires de pôles du générateur, il est ensuite décidé que le court-circuit existe dans le chemin côté haut ou que la défaillance existe dans le chemin côté bas.

7. Procédé selon la revendication 6, dans lequel lorsqu'il est décidé que le court-circuit existe dans le chemin côté haut ou que la défaillance existe dans le chemin côté bas, il est ensuite décidé en fonction d'une courbe temporelle d'une tension de phase, lequel de ces deux chemins est celui dans lequel le court-circuit existe.

**8.** Procédé selon la revendication 6 ou 7, dans lequel lorsqu'il est décidé que le court-circuit existe dans le chemin côté haut ou que la défaillance existe dans le chemin côté bas, une réduction de la valeur de l'intensité d'excitation ($I_E$) ou une pulsation de l'intensité d'excitation ($I_E$) est effectuée.

**9.** Procédé selon la revendication 5 ou 6, dans lequel la liste de défaillances possibles comprend la déconnexion d'une des phases (U, V, W, X, Y) du redresseur (130), et dans lequel il est décidé que la déconnexion existe lorsque la fréquence de défaillance déterminée correspond au double d'une vitesse de rotation du générateur multipliée par un nombre de paires de pôles du générateur.

**10.** Procédé selon l'une des revendications 4 à 9, dans lequel, lorsqu'il est reconnu qu'il existe une défaillance dans le groupe générateur, mais qu'il n'a pas été décidé qu'il s'agit d'une défaillance issue d'une liste de défaillances possibles, le générateur est mis hors tension.

**11.** Unité de calcul (140), en particulier régulateur d'alternateur, laquelle est disposée de façon à exécuter un procédé selon l'une des revendications précédentes.

**12.** Programme informatique, entraînant une unité de calcul (140) de façon à mettre en oeuvre un procédé selon l'une des revendications 1 à 10 lorsqu'il est exécuté sur l'unité de calcul (140).

**13.** Support d'enregistrement lisible par machine sur lequel est enregistré un programme informatique selon la revendication 12.

**Fig. 1**

EP 3 377 911 B1

**Fig. 2**

EP 3 377 911 B1

**Fig. 3**

EP 3 377 911 B1

Fig. 4

**Fig. 5**

EP 3 377 911 B1

**Fig. 6**

EP 3 377 911 B1

**Fig. 7**

EP 3 377 911 B1

Fig. 8

**Fig. 9**

u    f_F
o

A

a)

S

f

A

b)

S

f

SW    d

**Fig. 11**

**IN DER BESCHREIBUNG AUFGEFÜHRTE DOKUMENTE**

**In der Beschreibung aufgeführte Patentdokumente**

- DE 102015211933
- WO 2015028744 A2